# EUROPÄISCHE PATENTSCHRIFT

(11) **EP 1 235 661 B1**
(45) Veröffentlichungstag und Bekanntmachung des Hinweises auf die Patenterteilung: **10.05.2006**
(21) Anmeldenummer: 00977421.7
(22) Anmeldetag: 20.10.2000
(51) Int. Cl.: B23Q 39/02, B28D 1/00, H05K 3/00

(54) **TRENN- UND FRÄSVORRICHTUNG**
SEPARATING AND MILLING DEVICE
DISPOSITIF DE SEPARATION ET DE FRAISAGE

(30) Priorität: 21.10.1999 DE 29918534 U
(43) Veröffentlichungstag der Anmeldung: 04.09.2002
(73) Patentinhaber: IMT Gesellschaft für industrielle Maschinentechnologie MBH;, 35452 Heuchelheim (DE)
(72) Erfinder: ERB, Martin, 35463 Fernwald-Steinbach (DE)
(74) Vertreter: Böck, Bernhard
(86) Internationale Anmeldenummer: PCT/EP2000/010343
(87) Internationale Veröffentlichungsnummer: WO 2001/028738

(56) Entgegenhaltungen:
- DE-A- 2 932 289
- DE-U- 29 907 743
- FR-A- 2 167 572
- US-A- 3 099 298
- US-A- 4 589 174
- US-A- 4 907 337

## Beschreibung

Die Erfindung betrifft eine Trennvorrichtung, insbesondere zum Zerteilen von Leiterplatten, mit einer Kreissäge und einer Fräse , gemäß dem Oberbegriff des Anspruchs 1. Eine derartige Trennvorrichtung ist beispielsweise aus der FR-A-2 167 572 bekannt.

Leiterplatten werden in großen Stückzahlen heute in der Regel so hergestellt, dass zunächst eine große Leiterplatte und das sogenannte Leiterplatten-Mehrfachnutzen in Bereiche eingeteilt wird. Diese Bereiche entsprechen den späteren Leiterplatten. Nach der Einteilung werden die Bereiche mit Leiterbahnen versehen und anschließend mit den elektronischen Bauelementen bestückt und verlötet. Anschließend müssen aus dem Leiterplatten-Mehrfachnutzen nun die einzelnen Leiterplatten herausgetrennt werden. Dazu stehen im Wesentlichen zwei Verfahren zur Verfügung. Zum Einen können die Leiterplatten aus dem Leiterplatten-Mehrfachnutzen mittels einer Kreissäge bzw. einem gleichartigen rotierenden Schneidwerkzeug herausgeschnitten werden. Die Kreissäge eignet sich dabei insbesondere für gerade, im rechten Winkel zueinander verlaufende Trennschnitte. Der Vorteil dieses Trennverfahrens liegt insbesondere in der hohen Standzeit der Werkzeuge (Kreissägeblatt) und in der sehr hohen erreichbaren Taktzeit. Andererseits sind diese Kreissägen auf gerade verlaufende Trennschnitte beschränkt. Es kann jedoch notwendig sein, dass eine Leiterplatte eine unregelmäßig verformte Außenkontur hat. Zum Anderen können daher solche Leiterplatten mit einer Fräse aus dem Leiterplatten-Mehrfachnutzen herausgetrennt werden. Mit der Fräse können beliebige Konturen nachgefahren werden und Leiterplatten beliebiger Kontur aus dem Leiterplatten-Mehrfachnutzen herausgeschnitten werden.

Damit eine Trennvorrichtung für Leiterplatten-Mehrfachnutzen universell einsetzbar ist, weist sie daher sowohl eine Fräse als auch eine Kreissäge auf. Diese liegen oftmals in zwei baulich getrennten Schneideinrichtungen vor. Für diese beiden Schneideinrichtungen sind jeweils auf sie abgestimmte Steuerprogramme notwendig. Ebenso sind sowohl für die Kreissäge als auch für die Fräse eigene Antriebe erforderlich. Dies bedeutet zum Einen einen höheren entwicklungstechnischen Aufwand im Entwurf der Steuerung der Trennvorrichtung und zum Anderen eine höhere Anzahl von Bauteilen (Antrieben, Gehäusen, usw.) für die Schneideinrichtungen.

Der Erfindung liegt daher die Aufgabe zugrunde, eine Trennvorrichtung vorzuschlagen, welche aus wenigen Bauteilen gefertigt ist, gleichzeitig klein und kompakt ist, ein geringes Gewicht hat und einfach zu steuern ist.

Diese Aufgabe wird erfindungsgemäß mit den Merkmalen des Anspruches 1 gelöst. Bevorzugte Ausführungsformen werden in den abhängigen Ansprüchen offenbart.

Durch die Anordnung des Sägeblattes und des Fräsers auf einer gemeinsamen Welle ist eine Reduzierung der Einzelteile für die Trennvorrichtung möglich. Gleichzeitig bietet sich die Möglichkeit, eine kleine, kompakte und ein geringes Gewicht aufweisende Trennvorrichtung zu konstruieren. Dabei ist es vorteilhaft, dass das Sägeblatt und der Fräser am gleichen Ende der Welle angebracht sind.

Erfindungsgemäß ist die Welle in einem Gehäuse gelagert, wobei das Gehäuse selbst in einem Halter schwenkbar ist. Dadurch, dass das Sägeblatt und der Fräser auf einer gemeinsamen Welle angeordnet sind, liegen die Schnittebene der Fräse und der Kreissäge in einem Winkel von 90° zueinander, und ist es erforderlich, dass diese Welle um 90° geschwenkt werden kann, je nachdem mit welchem Werkzeug geschnitten werden soll. Damit also von einem Schneiden mit dem Fräser zu einem Schneiden mit dem Sägeblatt gewechselt werden kann, muss das Gehäuse mitsamt der Welle und dem darauf befindlichen Sägeblatt sowie dem Fräser gedreht werden. Dazu kann das Gehäuse erfindungsgemäß über zwei axial angeordnete Zapfen in dem Halter gelagert sein. Vorteilhaft ist dann die Welle in einem rechten Winkel zu den Zapfen angeordnet.

Der Antriebsmotor für die Welle ist erfindungsgemäß in dem Gehäuse untergebracht. Dadurch entfällt ein umständliches Antreiben der Welle durch einen feststehenden Motor mittels eines Getriebes oder ähnlichem.

Vorzugsweise kann auf einem der Zapfen ein Zahnrad befestigt sein, das mit einer von einer Kolben-Zylinder-Einheit angetriebenen Zahnstange in Eingriff steht. Mittels dieser Kolben-Zylinder-Einheit kann somit das Gehäuse um die durch die Zapfen verlaufende Achse gedreht werden. Dabei ist vorteilhaft der Schwenkbereich des Gehäuses durch zwei Anschläge begrenzt.

Durch das Drehen des Gehäuses bzw. durch das Wechseln vom Schneiden mit dem Fräser zum Schneiden mit dem Sägeblatt kann es zu einem Versatz der Schnittebene kommen. Dies ist insbesondere immer dann der Fall, wenn eine der Schnittebenen nicht die Schwenkachse des Gehäuses beinhaltet. Sobald die Schwenkachse außerhalb der Schnittebenen liegt, kommt es zu einem Versatz zwischen den Schnittebenen des jeweils aktuell genutzten und dem zuvor benutzten Werkzeug. Dieser Versatz kann erfindungsgemäß dadurch ausgeglichen werden, dass das Gehäuse von einem in einer Führung verschiebbaren Schlitten getragen ist. Der Schlitten ist dabei vorteilhaft mittels einer zweiten Kolben-Zylinder-Einheit verschiebbar.

In einer bevorzugten Ansführungsform ist es möglich, dass die durch die Zapfen gebildete Schwenkachse in der Ebene des Sägeblattes, d. h. in der Schnittebene der Kreissäge liegt.

Das Gehäuse ist vorzugsweise mit einem Spannverschluss, insbesondere einem Schnell-Spannverschluss für ein einfaches und unkompliziertes Wechseln des Fräsers ausgestattet. Dieser Spannverschluss kann vorzugsweise über eine Stange betätigbar sein, wobei diese Stange in der als Hohlwelle ausgebildeten Welle angeordnet ist. Diese Stange wird mittels einer Feder in der Verriegelungsstellung gehalten. Dadurch ist ein unabsichtliches Verlieren des Fräsers verhindert. Die Stange kann vorzugsweise mittels einer weiteren Kolben-Zylinder-Einheit verschiebbar sein.

Bei einer erfindungsgemäßen Trennvorrichtung ist der Halter mit dem Gehäuse für die Fräse und die Kreissäge zwar verschiebbar, so dass ein durch das Verschwenken des Gehäuses entstehender Schnittebenen-Versatz ausgeglichen werden kann, darüber hinaus ist der Halter bzw. die Führungseinrichtung, in welcher der Schlitten geführt ist, jedoch in der Regel ortsfest. Zum Ausschneiden der Leiterplatten wird dann vielmehr das Leiterplatten-Mehrfachnutzen entlang der vorgesehenen Schnittlinien verfahren. Es ist jedoch auch möglich, dass das Leiterplatten-Mehrfachnutzen während des Schneidens ortsfest gehalten wird. Dann kann jedoch die Führungseinrichtung selbst zusätzlich zu dem Halter in zumindest zwei Raumrichtungen verfahren werden.

Ein Ausführungsbeispiel ist anhand der Zeichnung näher erläutert. Darin zeigt
- Fig. 1: eine erfindungsgemäße Trennvorrichtung, teilweise im Schnitt,
- Fig. 2: eine Draufsicht auf die Trennvorrichtung gemäß Fig. 1,
- Fig. 3: eine perspektivische Ansicht der Trennvorrichtung gemäß Fig. 1 in Sägestellung,
- Fig. 4: eine Seitenansicht der Trennvorrichtung gemäß Fig. 3,
- Fig. 5: eine um 90° gedrehte Ansicht der Trennvorrichtung gemäß Fig. 4,
- Fig. 6: eine Draufsicht auf die Trennvorrichtung gemäß Fig. 3,
- Fig. 7: eine perspektivische Ansicht der Trennvorrichtung gemäß Fig. 1 in Frässtellung,
- Fig. 8: eine Seitenansicht der Trennvorrichtung gemäß Fig. 7,
- Fig. 9: eine um 90° gedrehte Ansicht der Trennvorrichtung gemäß Fig. 8 und
- Fig. 10: eine Draufsicht auf die Trennvorrichtung gemäß Fig. 7.

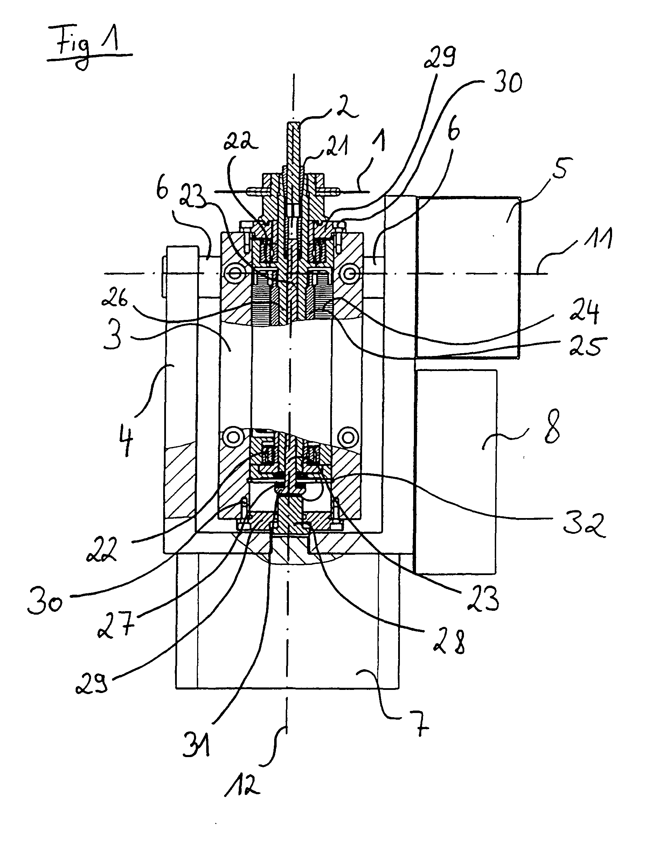

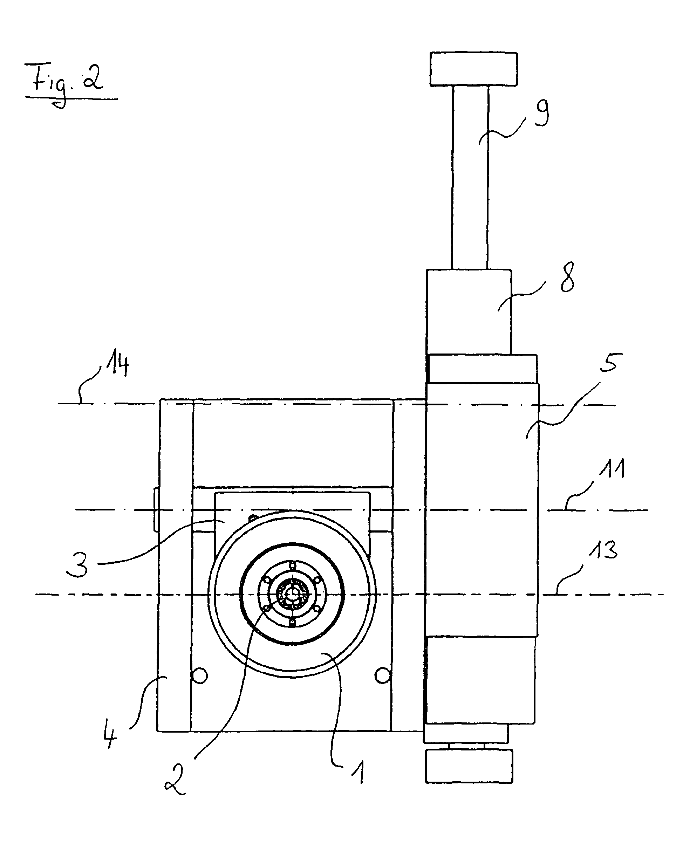

Die in Figuren dargestellte Trennvorrichtung weist ein hohlzylindrisches Gehäuse 3 auf, welches über zwei axiale Zapfen 6 an einem Halter 4 gelagert ist. Der Halter 4 ist an einem Schlitten 8 angebracht. Der Schlitten 8 ist auf einer Führungsschiene 9 (Fig. 2) verschiebbar gelagert. In dem Gehäuse 3 ist ein Antriebsmotor mit einem Ständer 24 und einem Läufer 25 untergebracht, wobei sich Ständer 24 und Läufer 25 über den überwiegenden Teil des Gehäuses 3 erstrecken (Fig. 1). Die Läuferwicklung ist auf einer Hohlwelle 26 angebracht, welche außerhalb des Ständers 24 über Lager 22 an dem Gehäuse 3 festgelegt ist. Das Gehäuse 3 ist beidseitig mit Deckeln 29 verschlossen, wobei die Deckel 29 mit Schrauben 30 an der Wand des Gehäuses 3 festgeschraubt sind. Der obere Deckel ist mit einer Ausnehmung versehen, durch welche die Hohlwelle aus dem Gehäuse herausgeführt ist. Außerhalb des Gehäuses 3 ist auf der Welle ein Sägeblatt 1 befestigt. Außerdem ist im oberen Ende der Hohlwelle als Spannverschluss eine Spannzange 21 für einen Fräser 2 vorgesehen. Diese Spannzange 21 ist mit einer Stange 23 verbunden, welche in der Hohlwelle 26 bis zum unteren Ende derselben geführt ist. An ihrem unteren Ende weist die Stange 23 einen Kopf auf, dessen Durchmesser den übrigen Durchmesser der Stange 23 übersteigt. Zwischen diesem so gebildeten Kopf 31 der Stange 23 der Hohlwelle 26 ist eine Feder 27 eingesetzt, welche die Stange 23 nach unten drückt. Dadurch wird die Spannzange 21 in einer geschlossenen Stellung gehalten, und der Fräser 2 ist in der Spannzange 23 festgelegt. Der untere Deckel 29 weist ebenfalls eine Ausnehmung auf, in welcher ein Bolzen 28 gelagert ist. Dieser Bolzen hat in der Frässtellung des Gehäuses einen geringfügigen Abstand zur Stange 23. Sein unteres Ende in der gezeigten Fräsposition des Gehäuses 3 ist mit einer Kolben-Zylinder-Einheit 7 verbunden, welche in den Zeichnungen nicht näher dargestellt ist. Einer der Zapfen 6 ist mit einem Zahnrad versehen, welches mit einer Zahnstange einer weiteren Kolben-Zylinder-Einheit 5 in Eingriff steht. Dieses ist ebensowenig im Detail dargestellt wie zwei Anschläge, zwischen welchen das Gehäuse 3 verschwenkbar ist.

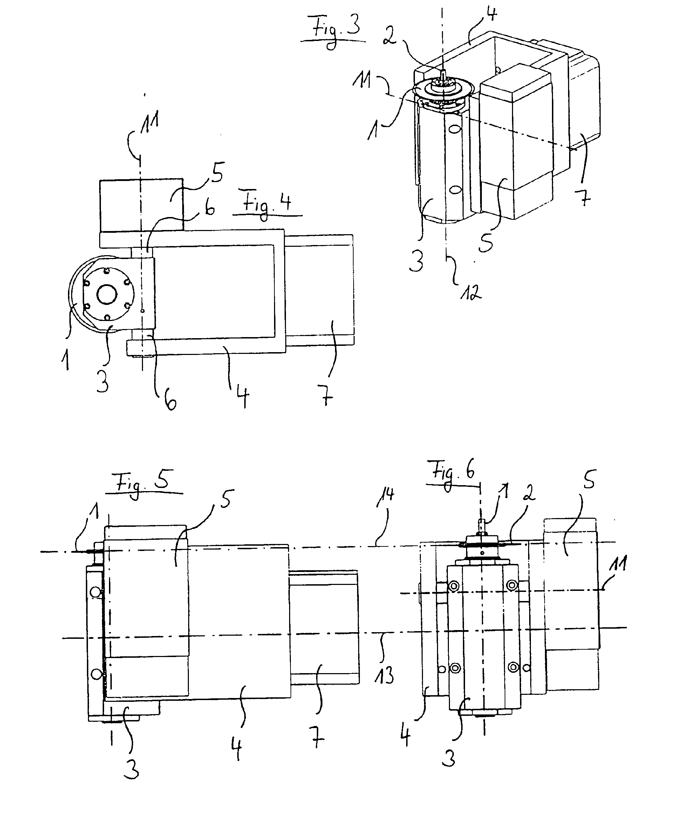

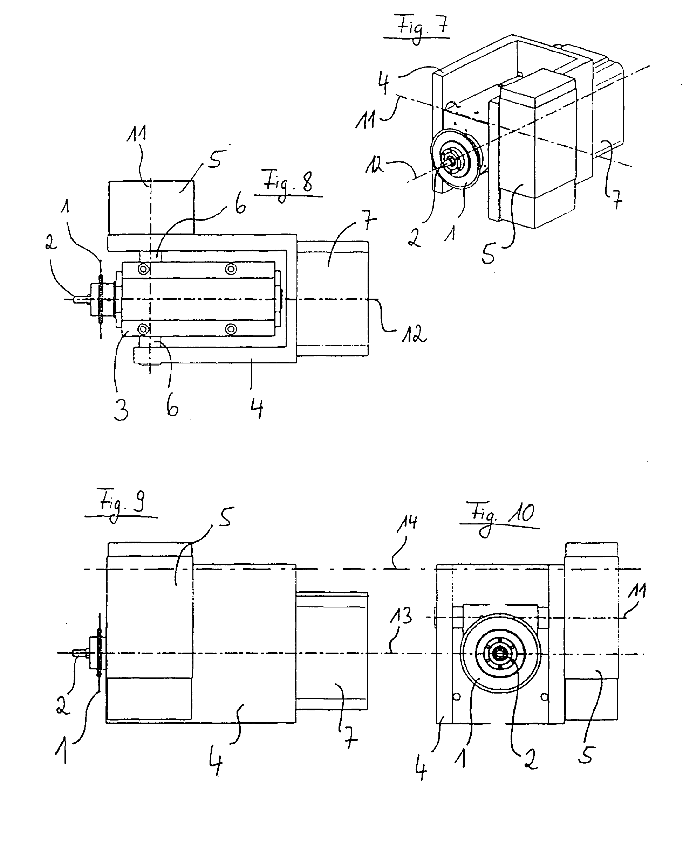

Die Funktionsweise der Trennvorrichtung soll im Folgenden an den Figuren 3 bis 10 erläutert werden, in welchen jedoch der Schlitten 8 und die Führungsschiene 9 nicht weiter beschrieben sind. Das Gehäuse 3 der Trennvorrichtung ist in der Darstellung der Figuren 3 bis 6 um die durch die Zapfen 6 gebildete Schwenkachse 11 in die Sägestellung geschwenkt. Das durch den Antriebsmotor angetriebene Sägeblatt 1 rotiert um die Drehachse 12 und liegt dabei in der Schnittebene 14, welche in Figur 4 parallel und in den Figuren 5 und 6 senkrecht zur Zeichnungsebene liegt. Die Lage dieser Schnittebene des Sägeblattes wird durch die Lage des Sägeblattes zur Schwenkachse 11 bestimmt und ist bezogen auf den Halter 4 unveränderlich.

In der Darstellung der Figuren 7 bis 10 ist das Gehäuse in die Frässtellung verschwenkt und wird in dieser Stellung durch die erste Kolben-Zylinder-Einheit 5 gegen einen Anschlag gedrückt, durch welchen die Frässtellung festgelegt ist. Durch die Drehachse 12 und den Abstand der Drehachse 12 von der Schwenkachse 11 ist die Lage der Schnittebene 13 festgelegt, in welcher der Fräser 1 schneidet. Diese Schnittebene 13 des Fräsers ist parallel zu der Schnittebene 14 des Sägeblattes, und die Position der Schnittebene 13 ist gegenüber dem Halter 4 ebenso unveränderlich, wie die Position der Schnittebene 14 des Sägeblattes.

Die Schnittebenen 13, 14 des Fräsers 2 und des Sägeblattes 1 sind bei diesem Ausführungsbeispiel zwar parallel, jedoch voneinander beabstandet. Die Steuerung der Trennvorrichtung, welche das Leiterplatten- Mehrfachnutzen entlang der zu schneidenden Linien verschiebt, müsste also so ausgelegt sein, dass entsprechend des gewählten Schneidwerkzeuges das Leiterplatten-Mehrfachnutzen verschoben wird, da die Schnittebenen 13 und 14 auseinanderfallen. Um diesen Versatz zwischen den Schnittebenen 13 und 14 aufzuheben und so auch eine entsprechend ausgelegte Steuerung für die Verschiebung der Leiterplatten-Mehrfachnutzen zu erübrigen, ist die Verschiebung des Halters 4 über den Schlitten 8 an der ortsfesten Führungsschiene 9 vorgesehen. Der Verschiebeweg des Schlittens 8 auf der Führungsschiene 9 ist gerade so bemessen, dass der durch das Verschwenken entstehende Versatz der Schnittebene 13 des Fräsers und der Schnittebene 14 des Sägeblattes bezüglich eines raumfesten Punktes ausgeglichen werden, obwohl die Schnittebenen 13, 14 bezüglich des Halters 4 ortsfest sind.

Der Vorteil der erfindungsgemäßen Trennvorrichtung ist, dass die bevorzugten Werkzeuge zum Trennen von Leiterplatten-Mehrfachnutzen in einer kleinen und kompakten, einen einzigen Antriebsmotor benötigenden Einheit zusammengefasst sind.

### Bezugszeichenliste

- 1: Sägeblatt
- 2: Fräser
- 3: Gehäuse
- 4: Halter
- 5: Kolben-Zylinder-Einheit für die Schwenkbewegung
- 6: Zapfen
- 7: Kolben-Zylinder-Einheit zum Lösen der Spannzange
- 8: Schlitten und Kolben-Zylinder-Einheit für die Längsverschiebung
- 9: Führungsschiene
- 11: Schwenkachse
- 12: Drehachse
- 13: Schnittebene des Fräsers
- 14: Schnittebene des Sägeblattes
- 21: Spannzange
- 22: Lager
- 23: Stange
- 24: Ständer
- 25: Läufer
- 26: Hohlwelle
- 27: Feder
- 28: Bolzen
- 29: Deckel
- 30: Deckelschrauben
- 31: Kopf der Stange
- 32: Lochscheibe

## Patentansprüche

1. Trennvorrichtung, insbesondere zum Zerteilen von Leiterplatten, mit einer Kreissäge und einer Fräse, wobei das Sägeblatt (1) der Kreissäge und der Fräser (2) der Fräse von einer gemeinsamen Welle (26) antreibbar und am gleichen Ende der Welle (26) angebracht sind und die Welle (26) in einem Gehäuse (3) gelagert ist, das über zwei axial angeordnete Zapfen (6) in einem Halter (4) schwenkbar gelagert ist, wobei weiter
der Antriebsmotor für die Welle (26) in dem Gehäuse (3) angeordnet ist, und wobei die Welle (26) in einem rechten Winkel zu den Zapfen (6) angeordnet ist **dadurch gekennzeichnet, dass** der Halter (4) von einem in einer Führung (9) verschiebbaren Schlitten (8) getragen ist.

2. Trennvorrichtung nach Anspruch 1, **dadurch gekennzeichnet, dass** auf einem der Zapfen (6) ein Zahnrad befestigt ist, das mit einer von einer Kolben-Zylinder-Einheit (5) angetriebenen Zahnstange in Eingriff steht.

3. Trennvorrichtung nach einem der Ansprüche 1 oder 2, **dadurch gekennzeichnet, dass** der Schwenkbereich des Gehäuses (3) durch zwei Anschläge begrenzt ist.

4. Trennvorrichtung nach einem der Ansprüche 1 bis 3, **dadurch gekennzeichnet, dass** der Schlitten (8) mittels einer zweiten Kolben-Zylinder-Einheit (7). verschiebbar ist.

5. Trennvorrichtung nach einem der Ansprüche 1 bis 4, **dadurch gekennzeichnet, dass** das Gehäuse (3) einen Spannverschluss (21) für den Fräser (2) aufweist.

6. Trennvorrichtung nach Anspruch 5, **dadurch gekennzeichnet, dass** der Spannverschluss (21) über eine Stange (23) betätigbar ist und dass die Stange (23) in der als Hohlwelle (26) ausgebildeten Welle angeordnet ist.

7. Trennvorrichtung nach Anspruch 6, **dadurch gekennzeichnet, dass** die Stange (23) mittels einer Feder (27) in der Verriegelungsstellung gehalten ist.

8. Trennvorrichtung nach Anspruch 7, **dadurch gekennzeichnet, dass** die Stange (23) mittels einer weiteren Kolben-Zylinder-Einheit (7) verschiebbar ist.

9. Trennvorrichtung nach einem der Ansprüche 1 bis 8, **dadurch gekennzeichnet, dass** die Führung des Schlittens (8) in zumindest zwei Raumrichtungen verfahrbar ist.

10. Trennvorrichtung nach einem der Ansprüche 1 bis 9, **dadurch gekennzeichnet, dass** die durch die Zapfen (6) bestimmte Schwenkachse in der Ebene des Sägeblattes (1) liegt.

## Claims

1. A separating device, in particular for the division of printed circuit boards, with a circular saw and a milling cutter, the blade (1) of the circular saw and the cutter (2) of the milling cutter being drivable by a common shaft (26) and being mounted at the same end of the shaft (26), and the shaft (26) being mounted in a housing (3) which is mounted so as to be pivotable in a holding means (4) by way of two pins (6) arranged axially, furthermore the drive motor for the shaft (26) being arranged in the housing (3), and the shaft (26) being arranged at a right angle to the pins (6), **characterized in that** the holding means (4) is carried by a slide (8) which is displaceable in a guide (9).

2. A separating device according to Claim 1, **characterized in that** a toothed wheel, which engages with a toothed rack driven by a piston-cylinder unit (5), is fastened to one of the pins (6).

3. A separating device according to one of Claims 1 or 2, **characterized in that** the pivoting range of the housing (3) is limited by two stops.

4. A separating device according to any one of Claims 1 to 3, **characterized in that** the slide (8) is displaceable by means of a second piston-cylinder unit (7).

5. A separating device according to any one of Claims 1 to 4, **characterized in that** the housing (3) has a clamping device (21) for the cutter (2).

6. A separating device according to Claim 5, **characterized in that** the clamping device (21) is actuable by way of a rod (23), and the rod (23) is arranged in the shaft constructed in the form of a hollow shaft (26).

7. A separating device according to Claim 6, **characterized in that** the rod (23) is held in the locking position by means of a spring (27).

8. A separating device according to Claim 7, **characterized in that** the rod (23) is displaceable by means of a further piston-cylinder unit (7).

9. A separating device according to any one of Claims 1 to 8, **characterized in that** the guide of the slide (8) is movable into at least two spatial directions.

10. A separating device according to any one of Claims 1 to 9, **characterized in that** the pivot axis determined by the pins (6) is situated in the plane of the saw blade (1).

## Revendications

1. Dispositif de désolidarisation, notamment pour démembrer des cartes de circuits imprimés, avec une scie circulaire et une fraise, la lame de scie (1) de la scie circulaire et la fraiseuse (2) de la fraise pouvant être entraînées par un arbre (26) commun, et étant disposées sur la même extrémité de l'arbre (26) et l'arbre (26) étant logée dans un carter (3), qui est logé de façon pivotante dans un support (4), par l'intermédiaire de deux tourillons (6) disposés de façon axiale, par ailleurs le moteur pour l'arbre (26) étant disposé dans le carter (3) et l'arbre (26) étant disposé en un angle droit par rapport aux tourillons (6), **caractérisé en ce que** le support (4) est porté par un chariot (8) déplaçable dans un guidage (9).

2. Dispositif de désolidarisation selon la revendication 1, **caractérisé en ce qu'**une roue dentée, qui s'engrène dans une crémaillère entraînée par une unité piston/cylindre (5), est fixée sur l'un des tourillons (6).

3. Dispositif de désolidarisation selon l'une quelconque des revendications 1 ou 2, **caractérisé en ce que** la plage de pivotement du carter (3) est délimitée par deux butées.

4. Dispositif de désolidarisation selon l'une quelconque des revendications 1 à 3, **caractérisé en ce que** le chariot (8) est déplaçable au moyen d'une deuxième unité piston/cylindre (7).

5. Dispositif de désolidarisation selon l'une quelconque des revendications 1 à 4, **caractérisé en ce que** le carter (3) comporte une fermeture à genouillère (21) pour la fraiseuse (2).

6. Dispositif de désolidarisation selon la revendication 5, **caractérisé en ce que** la fermeture à genouillère (21) est actionnable par l'intermédiaire d'une barre (23) et **en ce que** la barre (23) est disposée dans l'arbre conçu sous la forme d'un arbre creux (26).

7. Dispositif de désolidarisation selon la revendication 6, **caractérisé en ce que** la barre (23) est maintenue dans la position de verrouillage au moyen d'un ressort (27).

8. Dispositif de désolidarisation selon la revendication 7, **caractérisé en ce que** la barre (23) est déplaçable au moyen d'une autre unité piston/cylindre (7).

9. Dispositif de désolidarisation selon l'une quelconque des revendications 1 à 8, **caractérisé en ce que** le guidage du chariot (8) est déplaçable dans au moins deux directions dans l'espace.

10. Dispositif de désolidarisation selon l'une quelconque des revendications 1 à 9, **caractérisé en ce que** l'axe de pivotement déterminé par les tourillons (6) se situe dans le plan de la lame de scie (1).
